# EUROPEAN PATENT APPLICATION

(11) **EP 1 721 651 A1**
(43) Date of publication of application: **15.11.2006**
(21) Application number: 05709614.1
(22) Date of filing: 02.02.2005
(51) Int. Cl.: B01D 39/14, H05K 7/20

(54) **CLOSED TYPE DEVICE WITH HEAT RADIATING STRUCTURE, CASING USED FOR THE DEVICE, AND COMPOSITE SHEET**

(30) Priority: 03.02.2004 JP 2004026227
(71) Applicant: NEC CORPORATION, Minato-ku, Tokyo 108-0014 (JP)
(72) Inventor: KOMATSU, Kazuo c/o NEC Corporation, Minato-ku, Tokyo 1080014 (JP)
(74) Representative: Glawe, Delfs, Moll
(86) International application number: PCT/JP2005/001493
(87) International publication number: WO 2005/075049

(57) **Abstract**

A closed type device having excellent waterproofness and dustproofness, capable of preventing the entry of a corrosive gas, and having humidity conditioning function. In the heat radiating structure of the device (10), a ventilation hole (13) is formed in a part of the casing of the device formed of a casing body (11) and a door (12), and a composite sheet (14) formed by overlapping a carbon sheet in which the layer of activated carbon is held by permeable non-woven fabric with a fine-hole sheet having air permeability, waterproofness and dustproofness is fitted to the casing with the fine-hole sheet facing outward so as to cover the ventilation hole (13).

## Description

### Technical Field

The present invention relates to a closed type device with a heat radiating structure, and a casing and composite sheet used for the device. The closed type device according to the present invention is particularly suitable for outdoor use.

### Background Art

An example of a heat radiating structure of a closed type device is disclosed in Patent Document 1. According to the heat radiating structure of the closed type device disclosed in Patent Document 1, ventilation holes for heat radiation each including a plurality of through holes are formed both in upper and lower casings that constitute the closed type device, and each of the ventilation holes is covered with a fine-hole sheet having waterproofness and dustproofness from the inside of the device in order to prevent water or dust from intruding into the device through these ventilation holes.

Another example is disclosed in Patent Document 2, in which a ventilation hole for controlling an atmospheric pressure difference between the inside and outside of a sealed vessel that constitutes a disk storage unit containing a magnetic disk and a magnetic head is formed in the sealed vessel, and the ventilation hole is covered with dustproof filters, between which a gas absorption material achieved using a polymer-carbon fiber (preferably, acrylonitrile polymer-carbon fiber) having a cyano group is sandwiched, from the inside of the vessel in order to prevent dust or a corrosive/poisonous gas from intruding into the vessel through the ventilation hole.

Further, Patent Document 3 discloses a deodorant in which a deodorant structure containing an activated carbon fiber serving as an adsorptive medium having fine pores and cobalt phthalocyanine tetracarboxylic acid carried by the activated carbon fiber is provided inside a casing having a ventilation hole.
Patent Document 1: JP-A-10-13072
Patent Document 2: JP-A-9-35467
Patent Document 3: JP-A-2001-9019

### Disclosure of the Invention

### Problems to be Solved by the Invention

The heat radiating structure of the closed type device for outdoor use disclosed in Patent Document 1 can produce radiation effect with a simple structure not using a cooling system such as a heat pipe as well as provide waterproofness and dustproofness by an effect of the fine-hole sheet. However, although the fine-hole sheet can prevent droplets from intruding inside the device, it cannot prevent intrusion of vapor or corrosive gas which is composed of finer particles. Therefore, components such as electronic equipment mounted in the device are exposed to the corrosive gas, resulting in corrosion. Further, there is a tendency that the failure occurrence rate of electronic equipment significantly increases if the electronic equipment is operated for a long time under a marginal moisture condition. ,

If the filter disclosed in Patent Document 2 or deodorant disclosed in Patent Document 3 is used in place of the fine-hole sheet in the heat radiating structure of the closed type device for outdoor use disclosed in Patent Document 1, the following problem arises.

The sealed vessel disclosed in Patent Document 2 is designed for indoor use. Thus, the filter attached to the sealed vessel has dustproofness, whereas waterproofness is not taken into consideration. Similarly, the deodorant disclosed in Patent Document 3 does not have waterproofness. Therefore, in the case where the filter disclosed in Patent Document 2 or deodorant disclosed in Patent Document 3 is used in place of the fine-hole sheet in the heat radiating structure of the closed type device for outdoor use disclosed in Patent Document 1, it is possible to remove influence of the corrosive gas, whereas it is not possible to prevent intrusion of droplets such as rainwater. As a result, another problem arises also in terms of moisture control.

The present invention has been made in view of the above problem, and an object thereof is to provide a closed type device excellent in waterproofness and dustproofness, capable of preventing intrusion of a corrosive gas, and provided with a heat radiating structure having a moisture control function. Another object of the present invention is to provide a casing used for the heat radiating structure of such a closed type device and a composite sheet suitably used for achieving the heat radiating structure.

### Means for Solving the Problem

To solve the above problem, according to the present invention, there is provided a closed type device, comprising:
a heat radiating structure; and
a casing for encapsulating incorporated equipment,
wherein the heat radiating structure includes a ventilation hole formed in the casing and a composite sheet attached to the casing so as to cover the ventilation hole, and the composite sheet includes an outer sheet having air permeability, waterproofness and dustproofness, an inner sheet having air permeability, and a layer of activated carbon being sandwiched between the outer and inner sheets, the composite sheet being attached to the casing with the outer sheet facing outward and inner sheet facing inward.

It is preferable that the outer sheet has dustproofness and waterproofness above a level that satisfies IP (International Protection) 65 and permeability below a level of 13 Gurley seconds. IP65 means that the device is totally protected against intrusion of a powder and protected against jets of water. 13 Gurley seconds mean that it takes 13 seconds for 100 liters of air to pass through a sheet cross-section having an area of 645 cm² at a pressure of 1.23 kPa. Further, it is desirable that the inner sheet has air permeability equal to or greater than the air permeability of the outer sheet.

In one aspect of the present invention, the outer sheet includes at least one fine-hole sheet having a large number of fine pores.

In one aspect of the present invention, the outer sheet includes at least one fine-hole sheet having a large number of fine pores and at least one another sheet having air permeability. It is desirable that the at least one another sheet has air permeability equal to or greater than the air permeability of the fine-hole sheet.

In one aspect of the present invention, the inner sheet is a non-woven fabric.

In one aspect of the present invention, the inner sheet includes at least one fine-hole sheet having a large number of fine pores.

Further, to solve the above problem, according to the present invention, there is also provided a closed type device, comprising:
a heat radiating structure; and
a casing for encapsulating incorporated equipment,
wherein the heat radiating structure includes a ventilation hole formed in the casing and a composite sheet attached to the casing so as to cover the ventilation hole, and the composite sheet includes a carbon sheet including non-woven fabrics and a layer of activated carbon sandwiched between the non-woven fabrics and a fine-hole sheet having a large number of fine pores superposed on the carbon sheet, the composite sheet being attached to the casing with the fine-hole sheet facing outward and carbon sheet facing inward.

Further, to solve the above problem, according to the present invention, there is also provided a closed type device, comprising:
a heat radiating structure; and
a casing for encapsulating incorporated equipment,
wherein the heat radiating structure includes a ventilation hole formed in the casing and a composite sheet attached to the casing so as to cover the ventilation hole, and the composite sheet includes two fine-hole sheets each having a large number of fine pores and a layer of activated carbon sandwiched between the two fine-hole sheets.

Further, to solve the above problem, according to the present invention, there is also provided a closed type device, comprising:
a heat radiating structure; and
a casing for encapsulating incorporated equipment,
wherein the heat radiating structure includes a ventilation hole formed in the casing and a composite sheet attached to the casing so as to cover the ventilation hole, and the composite sheet includes a non-woven fabric, a fine-hole sheet having a large number of fine pores and a layer of activated carbon sandwiched between the non-woven fabric and fine-hole sheet, the composite sheet being attached to the casing with the fine-hole sheet facing outward and the non-woven fabric facing inward.

In one aspect of the present invention, a discharge hole is formed in the casing at the opposite position to the ventilation hole and a blower for introducing external air through the ventilation hole and discharging the air through the discharge hole is provided inside the casing.

In one aspect of the present invention, the casing has electrically conductive property and the layer of activated carbon and casing are electrically connected to each other.

In one aspect of the present invention, the ventilation hole is formed in a part of an openable door of the casing.

Further, to solve the above problem, according to the present invention, there is provided a closed type casing, comprising:
a heat radiating structure; and
a ventilation hole,
wherein the heat radiating structure includes the ventilation hole and a composite sheet attached to the casing so as to cover the ventilation hole, and the composite sheet includes an outer sheet having air permeability, waterproofness and dustproofness, an inner sheet having air permeability, and a layer of activated carbon being sandwiched between the outer and inner sheets, the composite sheet being attached to the casing with the outer sheet facing outward and inner sheet facing inward.

It is preferable that the outer sheet has dustproofness and waterproofness above a level that satisfies IP65 and permeability below a level of 13 Gurley seconds. Further, it is desirable that the inner sheet has air permeability equal to or greater than the air permeability of the outer sheet.

In one aspect of the present invention, the outer sheet includes at least one fine-hole sheet having a large number of fine pores.

In one aspect of the present invention, the outer sheet includes at least one fine-hole sheet having a large number of fine pores and at least one another sheet having air permeability. It is desirable that the at least one another sheet has air permeability equal to or greater than the air permeability of the fine-hole sheet.

In one aspect of the present invention, the inner sheet is a non-woven fabric.

In one aspect of the present invention, the inner sheet includes at least one fine-hole sheet having a large number of fine pores.

Further, to solve the above problem, according to the present invention, there is also provided a closed type casing, comprising:
a heat radiating structure; and
a ventilation hole,
wherein the heat radiating structure includes the ventilation hole and a composite sheet attached to the casing so as to cover the ventilation hole, and the composite sheet includes a carbon sheet including non-woven fabrics and a layer of activated carbon sandwiched between the non-woven fabrics and a fine-hole sheet having a large number of fine pores superposed on the carbon sheet, the composite sheet being attached to the casing with the fine-hole sheet facing outward and carbon sheet facing inward.

Further, to solve the above problem, according to the present invention, there is also provided a closed type casing, comprising:
a heat radiating structure; and
a ventilation hole,
wherein the heat radiating structure includes the ventilation hole and a composite sheet attached to the casing so as to cover the ventilation hole, and the composite sheet includes two fine-hole sheets each having a large number of fine pores and a layer of activated carbon sandwiched between the two fine-hole sheets.

Further, to solve the above problem, according to the present invention, there is also provided a closed type casing, comprising:
a heat radiating structure; and
a ventilation hole,
wherein the heat radiating structure includes the ventilation hole and a composite sheet attached to the casing so as to cover the ventilation hole, and the composite sheet includes a non-woven fabric, a fine-hole sheet having a large number of fine pores and a layer of activated carbon sandwiched between the non-woven fabric and fine-hole sheet, the composite sheet being attached to the casing with the fine-hole sheet facing outward and the non-woven fabric facing inward.

In one aspect of the present invention, a discharge hole for discharging external air introduced through the ventilation hole using a blower provided in the casing is formed in the casing at the opposite position to the ventilation hole.

In one aspect of the present invention, the casing has electrically conductive property and the layer of activated carbon and casing are electrically connected to each other.

In one aspect of the present invention, the ventilation hole is formed in a part of an openable door of the casing.

Further, to solve the above problem, according to the present invention, there is also provided a composite sheet comprising a carbon sheet including non-woven fabrics and a layer of activated carbon sandwiched between the non-woven fabrics and a fine-hole sheet having a large number of fine pores superposed on the carbon sheet.

Further, to solve the above problem, according to the present invention, there is also provided a composite sheet comprising two fine-hole sheets each having a large number of fine pores and a layer of activated carbon sandwiched between the two fine-hole sheets.

Further, to solve the above problem, according to the present invention, there is also provided a composite sheet comprising a non-woven fabric, a fine-hole sheet having a large number of fine pores and a layer of activated carbon sandwiched between the non-woven fabric and fine-hole sheet.

### Effect of the Invention

According to the closed type device and closed type casing having a heat radiating structure, external air is introduced inside the casing through a composite sheet covering a ventilation hole formed in the closed type casing to cool heat generated in incorporated equipment, thereby obtaining heat radiating effect and preventing intrusion of rain droplets or dust into the closed type casing by the composite sheet and intrusion of a corrosive gas into the closed type casing by activated carbon. Further, the activated carbon has a function of strongly absorbing/desorbing moisture, thereby enabling the moisture control in the closed type casing.

### Brief Description of Drawings

FIG. 1 (a) is a perspective view of an outdoor closed type device according to an embodiment of the present invention as viewed from the front side, FIG. 1 (b) is a perspective view of the same as viewed from the rear side, and FIG. 1 (c) is a partially cross-sectional view of the same;
FIG. 2 is an exploded view showing an example of a composite sheet used in the outdoor closed type device according to the embodiment of the present invention;
FIG. 3 is a view showing configuration example of a carbon sheet that constitutes the composite sheet and an enlarged view of fine pores of activated carbon;
FIG. 4 is a table showing a result of a salt-water spraying test;
FIG. 5 is a view showing a configuration around a door of the outdoor closed type device according to another embodiment of the present invention; and
FIG. 6 is a cross-sectional view showing another example of the main part of the composite sheet used in the outdoor closed type device according to the embodiments of the present invention,
wherein reference numeral 10 denotes an outdoor closed type device, 11 casing body, 12 door, 13 ventilation hole, 14 composite sheet, 14-1 fine-hole sheet, 14-1a adhesive tape, 14-2 carbon sheet, 14-2a adhesive tape, 14-21 non-woven fabric, 14-22 non-woven fabric, 14-23 activated carbon, 14-231 fine pore, 14-3 fine hole, 14-4 fine-hole sheet, 14-5 fine-hole sheet, 15 discharge hole, 16 hood, 17 heating part, and reference numeral 18 denotes a blower.

### Best Mode for Carrying Out the Invention

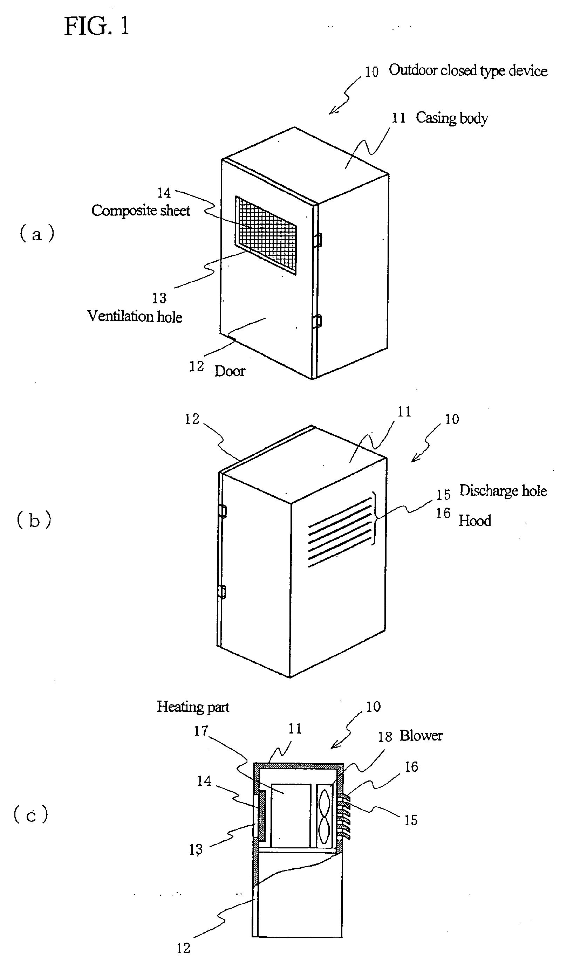

As shown in FIG. 1, an outdoor closed type device 10 according to an embodiment of the present invention includes a closed type casing constituted by a box-shaped casing body 11 made of a conductive metal, a door 12 made of a conductive metal which is attached to the casing body 11 in such a manner as to be opened and closed. The casing, which seals incorporated components contained in the inside thereof, has a ventilation hole 13 on a part of the door 12, and a composite sheet 14 is attached from the back surface side of the door 12 (i.e., from inside of the casing) so as to cover the ventilation hole 13.

Some slot-like discharge holes 15 are formed on the back surface of the casing body 11 at the opposite position to the ventilation hole 13 formed at the door 12. A part of each of the discharge holes 15 is covered by a hood 16 so as to prevent intrusion of raindrops.

Heating parts 17 such as electronic equipment including a radio unit, etc. serving as an incorporated equipment or control unit are disposed at the back of the ventilation hole 13 of the casing body 11. Further, a blower 18 for forcibly introducing external air through the ventilation hole 13 and discharging the air through the discharge holes 15 is disposed at the back of the heating parts 17.

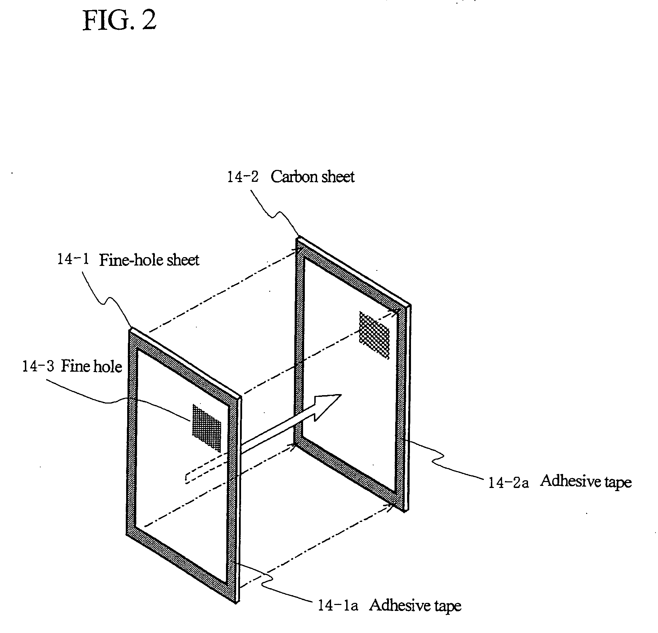

An example of the composite sheet 14 will be described with reference to FIG. 2. The composite sheet 14 has a structure in which one surface of a fine-hole sheet 14-1 having a size slightly larger than that of the ventilation hole 13 and one surface of a carbon sheet 14-2 having a size slightly larger than that of the ventilation hole 13 are placed face to face each other and adhered to each other by an adhesive tape 14-2a applied to the periphery of the surface of the carbon sheet 14-2 that faces the fine-hole sheet 14-1. The composite sheet 14 thus obtained is adhered to the back surface of the door 12 in such a manner as to cover the ventilation hole 13 by an adhesive tape 14-1a applied to the periphery of the other surface of the fine-hole sheet 14-1.

The fine-hole sheet 14-1 is made of a thin material on which a large number of fine holes or fine pores 14-3 are formed at a density of several hundreds of millions of holes per 1 cm². Accordingly, the fine-hole sheet 14-1 has IP65 level dustproofness and waterproofness and air permeability of 13 Gurley seconds, that is, the sheet lets air pass through but blocks water or dust from the outside. More specifically, the diameter of a fine hole or fine pores 14-3 is about 1 to 10 µm and thereby prevents intrusion of a liquid such as water droplet (in general, the diameter of rain droplets is about 2000 µm) or a solid such as dust. Meanwhile, a gas such as air or vapor (its diameter is about 0.001 µm) is freely passed through the sheet. As the fine-hole sheet 14-1, a sheet whose product name "Microtex" made and marketed by Nitto Denko Corporation is available.

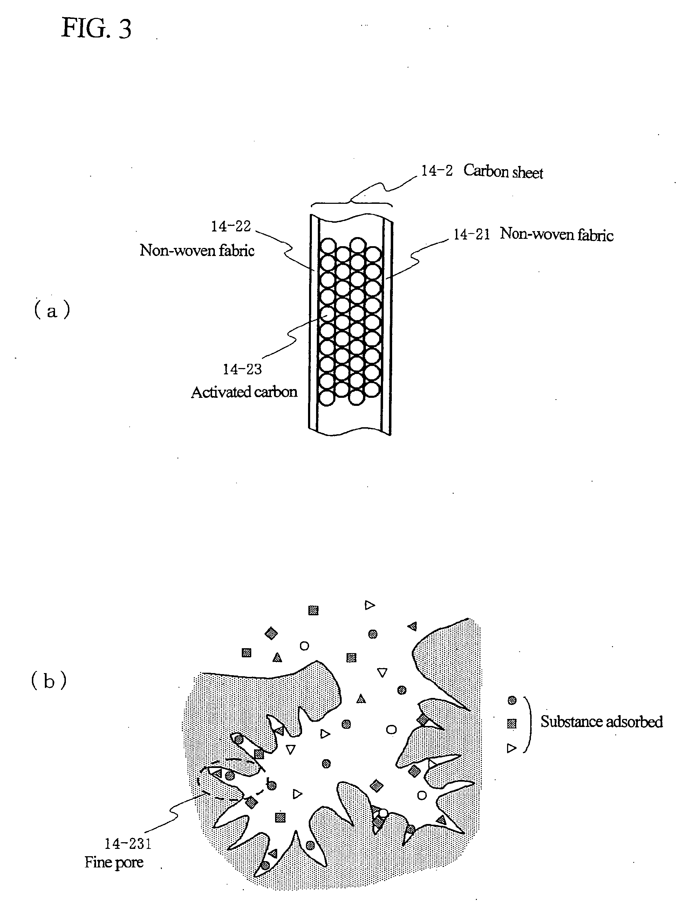

As shown in FIG. 3 (a), the carbon sheet 14-2 has a structure in which a layer of activated carbon 14-23 is sandwiched between two non-woven fabrics 14-21 and 14-22. Each of the non-woven fabrics 14-21 and 14-22 is made of synthetic fiber or synthetic resin and has excellent air permeability. The activated carbon, which is obtained by carbonizing a broadleaf tree or needle-leaved tree at about 900°C, is a granular substance having a diameter of several- ten microns and has a large number of fine pores 14-231 on the surface thereof as shown in FIG. 3 (b). The activated carbon has the property of allowing a corrosive gas such as sulfur dioxide, hydrogen sulfide, chlorine, and nitrogen dioxide to be absorbed to a large number of the fine pores 14-231 as well as moisture control property of repeating moisture absorption and moisture desorption. These properties appear prominently in activated carbon obtained from the needle-leaved tree such as Japanese cedar or pine tree. Further, the activated carbon has conductive property.

The outdoor closed type device 10 according to the present embodiment is installed outdoor. The blower 18 operates continuously for 24 hours per day. When the blower 18 is started its operation, external air is forcibly introduced from the ventilation hole 13 into the inside of the casing 11 through the composite sheet 14. At this time there is a fear that rain droplets, dust, vapor (moisture), or various kinds of corrosive gases intrude into the device depending on the installation site. However, rain droplets and dust are blocked by the fine-hole sheet 14-1 of the composite sheet 14 and therefore cannot intrude inside the casing 11. Although the vapor and corrosive gas pass through the fine-hole sheet 14-1, they are subjected to moisture absorption and absorbed to a large number of the fine pores 14-231 of the activated carbon 14-23 of the carbon sheet 14-2 and therefore cannot intrude any further. Further, the blower 18 forcibly discharges the air in the casing 11 to the outside through the discharge hole 15, preventing external air from intruding inside the casing 11 through the discharge hole 15.

As a result, it is possible to allow heat generated in the heating part 17 disposed in the casing 11 to escape outside, obtaining heat radiating effect and preventing intrusion of the rain droplets, dust, or corrosive gas into the casing 11. Further, the activated carbon has a function of strongly absorbing/desorbing moisture, thereby enabling the moisture control or regulation in the closed type casing.

Further, the activated carbon has electrically conductive property, and it follows that the ventilation hole 13 has electrically conductive property as the metal casing body 11 and door 12 have. In order to protect electronic parts incorporated in the casing from external electromagnetic wave noise or, contrary, in order to prevent electromagnetic wave noise generated in electronic parts from being diffused to the surrounding environment, it is sufficient to electromagnetically shield the electronic parts incorporated in the casing, in general. The electromagnetic wave shield can basically be achieved by enwrapping the circumference of an object to be electromagnetically shielded with a conductive material. Accordingly, since the entire casing including the ventilation hole 13 has conductive property as described above, the incorporated electronic parts can be electromagnetically shielded. However, in the structure shown in FIGS. 1 to 3, the activated carbon 14-23 and casing are not electrically connected to each other. Therefore, in order to increase the electromagnetic shield effect, it is preferable that the layer of the activated carbon 14-23 be electrically connected to the casing. To this end, it is sufficient to attach the composite sheet 14 to the back surface of the casing (specifically, the door 12 of the casing) using screws having conductive property at some points on the periphery of the composite sheet 14. As a result, the conductive screw is screwed into the door 12 through the non-woven fabric 14-21, layer of activated carbon 14-23, non-woven fabric 14-22, adhesive tape 14-2a, fine-hole sheet 14-1, and adhesive tape 14-1a and thereby the layer of the activated carbon 14-23 is electrically connected to the casing through the conductive screw. As a matter of course, the electrical connection between the activated carbon and casing may be achieved by any other methods. For example, a hole is drilled in the adhesive tapes 14-1a and 14-2a, fine-hole sheet 14-1, non-woven sheet 14-22 respectively at their positions corresponding to the part of composite sheet 14 for adhering to the casing so that the hole reaches the activated carbon 14-23 and, after that, a conductive adhesive is injected into the hole thus achieved, thereby establishing electrical connection between the layer of the activated carbon 14-23 and casing. When a conductive non-woven fabric is used as the non-woven fabrics 14-22 and 14-21, a more desirable effect can be obtained.

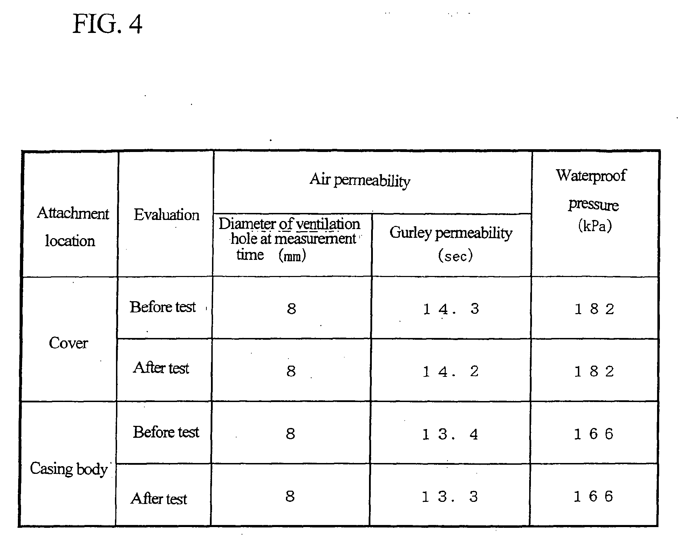

If the closed type device is set near the sea, the fine-hole sheet 14-1 or carbon sheet 14-2 of the composite sheet 14 may be clogged with salt-water crystal to make it hard to introduce external air into the device, resulting in a loss of radiation power. In light of the above, in order to check whether the composite sheet 14 according to the present invention is clogged with the salt-water crystal to result in a decrease of its air permeability, air permeability and waterproof pressure tests were made. According to JISC0024:2000, salt-water mist is sprayed onto the composite sheet 14 for 2 hours at a temperature of 35°C and the air permeability and waterproof pressure were measured after leaving the composite sheet 14 standing for 1 hour at a temperature of 40 ± 2°C and a relative humidity of 93%. In the tests, a closed type casing with a cover prepared for the test was used. Ventilation holes, each having a diameter of 8 mm, were formed respectively in the side surfaces of the cover and casing body and then covered with the composite sheet 14. The air permeability before and after the test was measured according to JISP8117 and the waterproof pressure before and after the test was measured according to JISL1092. The result is shown in FIG. 4. As can be seen from FIG. 4, the air permeability and waterproof pressure remained substantially unchanged before and after the salt-water spraying test. As a result, it was possible to confirm that the fine-hole sheet 14-1 and carbon sheet 14-2 of the composite sheet 14 had not been clogged with salt-water crystal.

In the above embodiment, one ventilation hole 13 with composite sheet is provided in the outdoor closed type device 10. However, the number and size of the ventilation holes 13 should be defined depending on the cooling capacity required for the closed type device and therefore a plurality of ventilation holes 13 with composite sheet may be provided. In this case, although it is preferable that the discharge holes 15 be formed in the casing body at the opposite positions to the respective ventilation holes 15 and blowers 18 be disposed between them, respectively, a configuration in which the blower 18 or discharge hole 15 is shared by some ventilation holes 13 may be adopted.

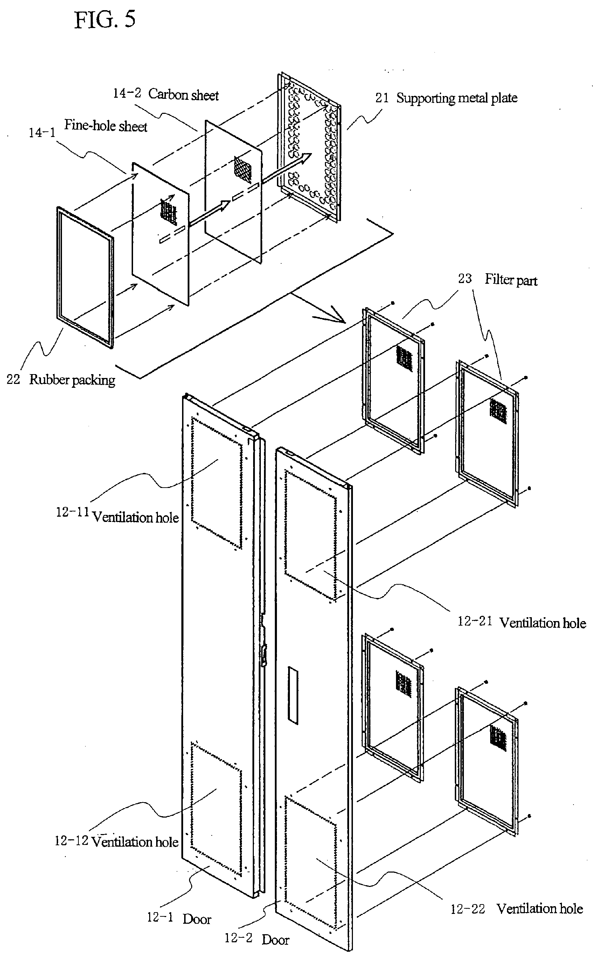

FIG. 5 shows an example in which a double swing door (doors 12-1 and 12-2) are used in place of the door 12, and two ventilation holes (a pair of ventilation holes 12-11, 12-12, and pair of ventilation holes 12-21, 12-22) are formed respectively on the doors 12-1 and 12-2. Further, in this example, the composite sheet is attached to the ventilation hole without using the adhesive tape. That is, filter parts 23 each obtained by stacking a carbon sheet 14-2, a fine-hole sheet 14-1 and a rubber packing 22 in this order on a supporting metal plate 21 are attached respectively to the back surfaces of the doors 12-1 and 12-2 by screws. In this example, electrical connection between the casing and activated carbon can be established by using a rubber packing 22 having conductive property. More specifically, a hole is formed in a part of the fine-hole sheet 14-1, which contacts the conductive rubber packing 22, and a part of the non-woven fabric of the carbon sheet 14-2 on the back of the fine-hole sheet 14-1, and the rubber packing is brought into press contact with the layer of the activated carbon in the carbon sheet 14-2.

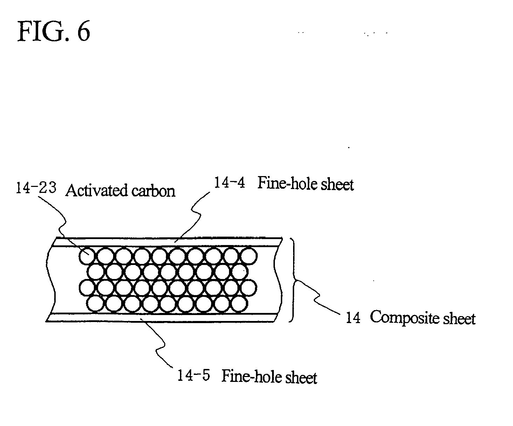

Another example of the composite sheet 14 will be described with reference to FIG. 6. The composite sheet 14 in this example has a structure in which the layer of the activated carbon 14-23 is sandwiched between two fine-hole sheets 14-4 and 14-5. The material and property of the fine-hole sheets 14-4 and 14-5 are the same as those of the fine-hole sheet 14-1 shown in FIG. 2. An example of a fabricating method of such a composite sheet is as follows.

Firstly, powdered resin (polyethylene, etc.) is dusted uniformly on one surface of the fine-hole sheet and melted by heat to obtain two sheets on one surface of each of which has been subjected to resin coating (sinter treatment). The obtained two sheets are used as an upper base sheet and a lower base sheet. Subsequently, a powder compound is obtained by mixing the activated carbon and the same powdered resin as above. Subsequently, the powder compound is placed on the resin-coated surface of the lower base sheet and the upper base sheet is placed on the lower base sheet with the resin-coated surface of the upper base sheet facing downward, followed by pressure bonding using a heating roller. Finally, the obtained composite sheet is cut into a predetermined size, thereby obtaining the composite sheet 14. In this fabricating method, the powdered resin is used to bond the fine-hole sheet and activated carbon to each other as well as activated carbons to each other, so that the bonding is made in a point-contact manner to thereby minimize adhesion of resin coating to the activated carbon, preventing performance of the activated carbon from being significantly reduced.

It is possible to reduce the number of sheets to be used in the example of the composite sheet shown in FIG. 6 as compared with the number of sheets to be used in the example of FIG. 2 and, correspondingly, it is possible to reduce the thickness of the composite sheet. Although two fine-hole sheets are used to constitute the composite sheet of FIG. 6, one of the two fine-hole sheets can be replaced by a non-woven fabric made of synthetic fiber or synthetic resin. In this case, it is possible to reduce the number of comparatively expensive fine-hole sheets. However, in the case where the lower side fine-hole sheet 14-5 of FIG. 6 is replaced with the non-woven fabric, it is necessary to attach the composite sheet to the ventilation hole 13 with the upper side fine-hole sheet 14-4 facing outside.

Although the ventilation hole is formed in the door of the outdoor closed type device 10 in consideration of the maintainability of the composite sheet in the above embodiments, the ventilation hole may be provided in any part of the device casing other than the door.

Although a forced-air cooling system that forcibly introduces external air into the device using the blower 18 is adopted in the above embodiment, a natural-air cooling system that does not use the blower 18 may be adopted. In this case, it is preferable that the composite sheet 14 be attached to the discharge hole 15 as well as the ventilation hole 13 or that the discharge hole 15 itself be not provided to prevent intrusion of the dust or corrosive gas.

Although a planar composite sheet is used in the above embodiments, a part or entire of the composite sheet may be processed into a wave-like or corrugated form.

### Industrial Applicability

As described above, the closed type device or closed type casing according to the present invention, which encapsulates electronic equipment such as a radio unit, is useful especially for outdoor use and, more particularly, for use in an outdoor environment where the device is exposed to the rain droplets, dust, or corrosive gas.

## Claims

1. A closed type device, comprising:
a heat radiating structure; and
a casing for encapsulating incorporated equipment,
wherein the heat radiating structure includes a ventilation hole formed in the casing and a composite sheet attached to the casing so as to cover the ventilation hole, and the composite sheet includes an outer sheet having air permeability, waterproofness and dustproofness, an inner sheet having air permeability, and a layer of activated carbon being sandwiched between the outer and inner sheets, the composite sheet being attached to the casing with the outer sheet facing outward and inner sheet facing inward.

2. The closed type device as claimed in claim 1, wherein the outer sheet includes at least one fine-hole sheet having a large number of fine pores.

3. The closed type device as claimed in claim 1, wherein the outer sheet includes at least one fine-hole sheet having a large number of fine pores and at least one another sheet having air permeability.

4. The closed type device as claimed in claim 1, wherein the inner sheet is a non-woven fabric.

5. The closed type device as claimed in claim 1, wherein the inner sheet includes at least one fine-hole sheet having a large number of fine pores.

6. A closed type device, comprising:
a heat radiating structure; and
a casing for encapsulating incorporated equipment,
wherein the heat radiating structure includes a ventilation hole formed in the casing and a composite sheet attached to the casing so as to cover the ventilation hole, and the composite sheet includes a carbon sheet including non-woven fabrics and a layer of activated carbon sandwiched between the non-woven fabrics and a fine-hole sheet having a large number of fine pores superposed on the carbon sheet, the composite sheet being attached to the casing with the fine-hole sheet facing outward and carbon sheet facing inward.

7. A closed type device, comprising:
a heat radiating structure; and
a casing for encapsulating incorporated equipment,
wherein the heat radiating structure includes a ventilation hole formed in the casing and a composite sheet attached to the casing so as to cover the ventilation hole, and the composite sheet includes two fine-hole sheets each having a large number of fine pores and a layer of activated carbon sandwiched between the two fine-hole sheets.

8. A closed type device, comprising:
a heat radiating structure; and
a casing for encapsulating incorporated equipment,
wherein the heat radiating structure includes a ventilation hole formed in the casing and a composite sheet attached to the casing so as to cover the ventilation hole, and the composite sheet includes a non-woven fabric, a fine-hole sheet having a large number of fine pores and a layer of activated carbon sandwiched between the non-woven fabric and fine-hole sheet, the composite sheet being attached to the casing with the fine-hole sheet facing outward and the non-woven fabric facing inward.

9. The closed type device as claimed in any one of claims 1 to 8, wherein a discharge hole is formed in the casing at the opposite position to the ventilation hole and a blower for introducing external air through the ventilation hole and discharging the air through the discharge hole is provided inside the casing.

10. The closed type device as claimed in any one of claims 1 to 8, wherein the casing has electrically conductive property and the layer of activated carbon and casing are electrically connected to each other.

11. The closed type device as claimed in any one of claims 1 to 8, wherein the ventilation hole is formed in a part of an openable door of the casing.

12. A closed type casing, comprising:
a heat radiating structure; and
a ventilation hole,
wherein the heat radiating structure includes the ventilation hole and a composite sheet attached to the casing so as to cover the ventilation hole, and the composite sheet includes an outer sheet having air permeability, waterproofness and dustproofness, an inner sheet having air permeability, and a layer of activated carbon being sandwiched between the outer and inner sheets, the composite sheet being attached to the casing with the outer sheet facing outward and inner sheet facing inward.

13. The closed type casing as claimed in claim 12, wherein the outer sheet includes at least one fine-hole sheet having a large number of fine pores.

14. The closed type casing as claimed in claim 12, wherein the outer sheet includes at least one fine-hole sheet having a large number of fine pores and at least one another sheet having air permeability.

15. The closed type casing as claimed in claim 12, wherein the inner sheet is a non-woven fabric.

16. The closed type casing as claimed in claim 12, wherein the inner sheet includes at least one fine-hole sheet having a large number of fine pores.

17. A closed type casing, comprising:
a heat radiating structure; and
a ventilation hole,
wherein the heat radiating structure includes the ventilation hole and a composite sheet attached to the casing so as to cover the ventilation hole, and the composite sheet includes a carbon sheet including non-woven fabrics and a layer of activated carbon sandwiched between the non-woven fabrics and a fine-hole sheet having a large number of fine pores superposed on the carbon sheet, the composite sheet being attached to the casing with the fine-hole sheet facing outward and carbon sheet facing inward.

18. A closed type casing, comprising:
a heat radiating structure; and
a ventilation hole,
wherein the heat radiating structure includes the ventilation hole and a composite sheet attached to the casing so as to cover the ventilation hole, and the composite sheet includes two fine-hole sheets each having a large number of fine pores and a layer of activated carbon sandwiched between the two fine-hole sheets.

19. A closed type casing, comprising:
a heat radiating structure; and
a ventilation hole,
wherein the heat radiating structure includes the ventilation hole and a composite sheet attached to the casing so as to cover the ventilation hole, and the composite sheet includes a non-woven fabric, a fine-hole sheet having a large number of fine pores and a layer of activated carbon sandwiched between the non-woven fabric and fine-hole sheet, the composite sheet being attached to the casing with the fine-hole sheet facing outward and the non-woven fabric facing inward.

20. The closed type casing as claimed in any one of claims 12 to 19, wherein a discharge hole for discharging external air introduced through the ventilation hole using a blower provided in the casing is formed in the casing at the opposite position to the ventilation hole.

21. The closed type casing as claimed in any one of claims 12 to 19, wherein the casing has electrically conductive property and the layer of activated carbon and casing are electrically connected to each other.

22. The closed type casing as claimed in any one of claims 12 to 19, wherein the ventilation hole is formed in a part of an openable door of the casing.

23. A composite sheet comprising a carbon sheet including non-woven fabrics and a layer of activated carbon sandwiched between the non-woven fabrics and a fine-hole sheet having a large number of fine pores superposed on the carbon sheet.

24. A composite sheet comprising two fine-hole sheets each having a large number of fine pores and a layer of activated carbon sandwiched between the two fine-hole sheets.

25. A composite sheet comprising a non-woven fabric, a fine-hole sheet having a large number of fine pores and a layer of activated carbon sandwiched between the non-woven fabric and fine-hole sheet.
